# EUROPEAN PATENT APPLICATION

(11) **EP 2 209 132 A1**
(43) Date of publication of application: **21.07.2010**
(21) Application number: 09150786.3
(22) Date of filing: 16.01.2009
(51) Int. Cl.: H01J 37/34

(54) **Charged particle beam PVD device, shielding device, coating chamber for coating substrates, and method of coating**

(71) Applicant: Applied Materials, Inc., Santa Clara, CA 95054 (US)
(72) Inventor: Krempel-Hesse, Joerg, 63683 Eckartsborn (DE); Grillmayer, Juergen, 60313 Frankfurt (DE); Hermanns, Uwe, 63486 Bruchkoebel (DE)
(74) Representative: Zimmermann & Partner

(57) **Abstract**

A charged particle beam PVD device is provided, including a target (262) of coating material inside of a casing (261), a vapor aperture (263) provided in the casing, and a shielding device (266, 268; 2680) provided adjacent to the vapor aperture, the shielding device being on floating potential.

## Description

### TECHNICAL FIELD OF THE INVENTION

Embodiments described herein relate to a charged particle beam PVD device, a shielding device, a coating chamber for coating substrates, and a method of coating. Particular embodiments relate to a charged particle beam PVD device for a coating chamber for coating substrates, a shielding device for a charged particle beam PVD device, a coating chamber for coating substrates, and a method of coating one or more substrates in a coating chamber.

### BACKGROUND OF THE INVENTION

Thin-film coating of material on e.g. plate-shaped substrates may be accomplished in many ways, for example by evaporation or sputtering of the coating material.

In some known vacuum installations for coating substrates, e.g. glass substrates, with thin layers by PVD (Physical Vapor Deposition) using cathode sputtering, several compartments are located one after another. At least one of the compartments includes at least one sputtering cathode and process gas inlets and is connected with a vacuum pump for evacuation. The compartments may be connected to one another by means of openings, typically vacuum locks or airlocks, which may include one or more slit valves. As a substrate support, a transport system including transport rolls for transporting the substrates along a path in front of, e.g. below, the sputtering cathode(s) and passing the substrates through the openings between the compartments may be provided.

In one example of operating a sputtering cathode, plasma is established and ions of the plasma are accelerated onto a target of coating material to be deposited onto the substrates. This bombardment of the target results in ejection of atoms of the coating material which pass a sputtering aperture of the sputtering cathode and accumulate as a deposited film on the substrates.

In a typical example, for instance for coating continuously transported plate-shaped substrates, an elongated sputtering cathode having an elongated sputtering aperture may be used. The elongated sputtering aperture may span the widths, e.g. the dimension perpendicular to the transport direction, of the plate-shaped substrates transported in front of the sputtering aperture. In some known sputtering coating operations using an elongated sputtering cathode, parts of the substrate support, e.g. lateral parts, may be undesirably coated. Thick layers of coating material on the substrate support may absorb humidity from atmosphere when the chamber is vented, which may lead to instabilities during the coating process. Furthermore, the thickness of the coatings deposited on the substrates may be not uniform across the widths of the substrates. In addition, the erosion profile of the target may not be uniform throughout the sputtering area of the target.

### SUMMARY

In light of the above, a charged particle beam PVD device according to independent claim 1, a shielding device according to independent claim 9, a coating chamber according to independent claim 11, and a method of coating one or more substrates in a coating chamber according to claim 14 are provided.

In one embodiment, a charged particle beam PVD device is provided, including a target of coating material inside of a casing, a vapor aperture provided in the casing, and a shielding device provided adjacent to the vapor aperture, the shielding device being on floating potential.

In a further embodiment, a shielding device for a charged particle beam PVD device is provided, the charged particle beam PVD device including an target of coating material inside of a casing and a vapor aperture provided in the casing, the shielding device being adapted to be provided adjacent to the vapor aperture and being adapted to be provided on floating potential.

In another embodiment, a coating chamber for coating substrates is provided, including a substrate support, and a charged particle beam PVD device including a target of coating material inside of a casing, a vapor aperture provided in the casing, and a shielding device provided adjacent to the vapor aperture, the shielding device being on floating potential.

In yet another embodiment, a method of coating one or more substrates in a coating chamber is provided, including: providing a substrate on a substrate support of the coating chamber having a charged particle beam PVD device, wherein the charged particle beam PVD device includes a target of coating material inside of a casing, a vapor aperture provided in the casing, and a shielding device provided adjacent to the vapor aperture, the shielding device being on floating potential; and dispensing coating material from the charged particle beam PVD device towards the substrate.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

### BRIEF DESCRIPTION OF THE DRAWINGS

So that the manner in which the above recited features can be understood in detail, a more particular description of embodiments of the invention, briefly summarized above, may be had by reference to embodiments. The accompanying drawings relate to embodiments of the invention and are described in the following. Some of the above mentioned embodiments will be described in more detail in the following description of typical embodiments or examples thereof with reference to the following drawings in which:

Fig. 1 shows schematically a cross-sectional view of a coating chamber including two charged particle beam PVD devices according to embodiments described herein;

Fig. 2 shows schematically a cross-sectional view of the coating chamber illustrated in Fig. 1 along line A-A;

Fig. 3 shows a flow diagram of a method according to embodiments described herein;

Fig. 4 illustrates schematically a bottom view of one of the charged particle beam PVD devices shown in Fig. 1;

Fig. 5 shows schematically a partial cross-sectional view of a charged particle beam PVD device including an isolating connector, according to embodiments described herein;

Figs. 6a and 6b each illustrate schematically a structure of an isolating connector of a charged particle beam PVD device according to embodiments described herein; and

Figs. 7a and 7b illustrate schematically a coating chamber and a bottom view of a charged particle beam PCD device, respectively, according to embodiments described herein.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

A typical application of the charged particle beam PVD device, the shielding device, the coating chamber and the coating method of embodiments described herein is in PVD (Physical Vapor Deposition) compartments, e.g. vacuum sputtering compartments, of coating installations. Hence, the charged particle beam PVD device, the shielding device and the coating chamber may include or consist of vacuum compatible materials. The charged particle beam PVD device may particularly be utilized in installations for coating continuously or discontinuously conveyed plate-shaped substrates with thin films. The embodiments are especially useful when coating glass substrates, e.g. plate-shaped glass substrates, with thin metal films, for example with Ag films, for instance in the manufacture of solar cells.

The charged particle beam PVD device of embodiments described herein may be for instance an electron beam PVD device, an ion beam PVD device, a sputtering device, a plasma sputtering device, a charged particle beam sputtering device, an electron beam sputtering device, or an ion beam sputtering device.

Without limiting the scope, the following is directed to a plasma sputtering device as a charged particle beam PVD device for coating a substrate in a vacuum coating chamber. Embodiments described herein may be for thin-film Ag coating of rectangular plate-shaped glass substrates. Embodiments can also be applied to other charged particle beam PVD devices and coating methods, and other coating materials than Ag, e.g. other metals or alloys, such as Al. Furthermore, other substrates, such as a web or plastic films, having modified shapes may be employed. Moreover, the substrate(s) may be delivered to the coating chamber continuously or may be provided in the coating chamber in a discontinuous mode. In addition, the coating chamber is not limited to a vacuum chamber. Without limiting the scope, a vapor aperture of the charged particle beam PVD device may also be referred to herein as sputtering aperture. Further, a target of the charged particle beam PVD device may be referred to herein as sputtering target.

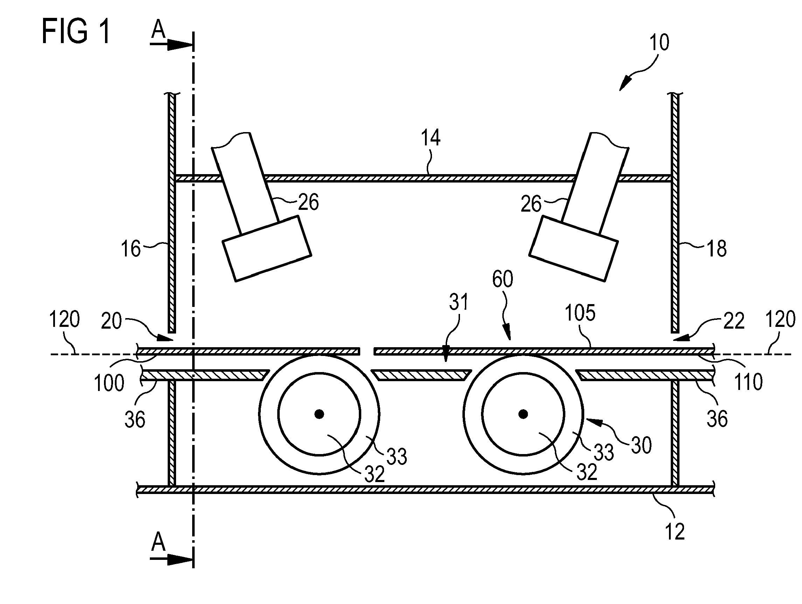

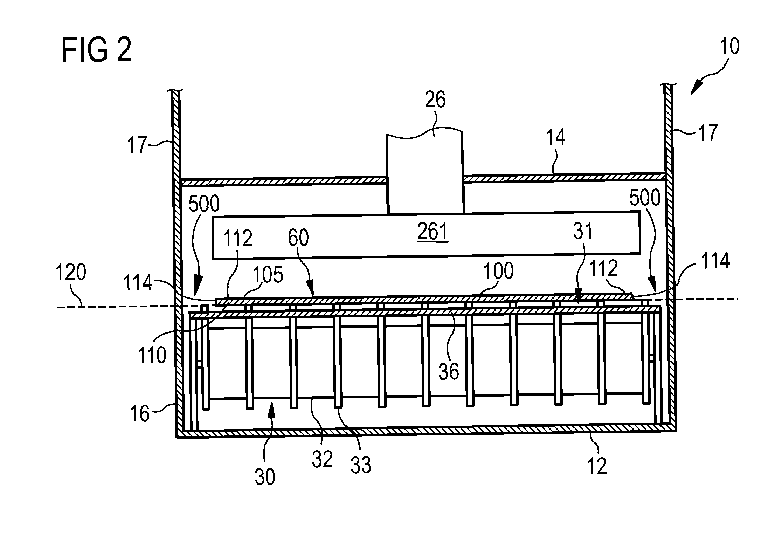

Fig. 1 illustrates, as a typical example, a cross-sectional view of a coating chamber 10 designed as a vacuum sputtering chamber for thin-film coating of continuously transported rectangular plate-shaped glass substrates 100. Fig. 2 shows a cross-sectional view of the coating chamber 10 according to Fig. 1, along line A-A. The coating chamber 10 includes a bottom wall 12, a top wall 14, a front wall 16, a rear wall 18 and two sidewalls 17. The material of all walls is stainless steel and the coating chamber 10 is vacuum-tight. The front wall 16 includes a substrate feeding opening 20 and the rear wall 18 includes a substrate discharge opening 22. The substrate feeding and discharge openings 20, 22 may be designed as vacuum locks or airlocks, typically as slit valves, for maintaining a vacuum in the coating chamber 10 when feeding and discharging the glass substrates 100. The coating chamber 10 further has process gas inlets (not shown) and is connected to vacuum pumps (not shown) for establishing a vacuum of about 10⁻⁶ Torr. The pressure value of 10⁻⁶ Torr should, of course, be understood as an example while other pressure values or ranges are also applicable. For example, a typical pressure range for sputtering is between 10⁻³ hPa to 10⁻² hPa, a typical pressure range for evaporation is from lower than 10⁻⁶ hPa to 10⁻³ hPa, more typically in the range from 10⁻⁵ hPa to 10⁻⁴ hPa.

Furthermore, at the top wall 14 at least one plasma sputtering cathode 26, typically two sputtering cathodes 26, each including a target of Ag is provided as a plasma sputtering device for dispensing coating material into the coating chamber. The plasma sputtering cathode 26 is also referred to herein as sputtering cathode 26.

On the bottom wall 12, as a substrate support, a transport system 30 for continuously conveying a plurality of glass substrates 100 is mounted, as is shown in Fig. 1 and 2. The transport system 30 has a front side 31 facing the sputtering cathode 26 and is adapted for supporting on the front side 31 one or more plate-shaped glass substrates 100. The transport system 30 includes a plurality of, typically two, rotatable rolls 32 arranged in parallel to each other throughout the coating chamber 10 successively from the front wall 16 to the rear wall 18. The rolls 32 extend from one sidewall 17 to the opposite sidewall 17. Furthermore, each roll 32 is positioned below a cover panel 36 of the transport system 30 and includes a plurality of spaced apart rings 33 being each concentrically attached to the roll 32. The rings 33 extend through openings in the cover panel 36 of the transport system 30 and support the glass substrates 100 and, thereby, define a substrate support plane 120 above the cover panel 36. The substrate support plane 120 is shown in Figs. 1 and 2 as a dashed line. Front sides 105 of the glass substrates 100 supported on the rings 33 face the sputtering cathodes 26. The cover panel 36 is disposed at the front side 31 of the transport system and has an installation height such that it is positioned typically about 2 mm to about 12 mm beneath the substrate support plane 120.

In an alternative design (not shown in the Figures) of the transport system, the diameter of the plurality of rolls may be much smaller than the diameter of the plurality of rings. Each ring may then be attached to a wheel which is attached to one of the rolls. Hence, each roll may have a plurality of spaced apart wheels being each concentrically attached to the roll. Each wheel may support one ring at the outermost circumference of the wheel. The rings support the glass substrates 100 and, thereby, define the substrate support plane 120, also referred to herein as support plane 120, at the front side 31 of the substrate support.

The rolls 32 are connected to a driving unit (not shown), which is connected to a control unit (not shown). The transport system 30 is made for conveying the plate-shaped glass substrates 100 in a transport direction along a transport path 60. The transport path 60 is defined by the transported glass substrates 100 and is positioned on the substrate support plane 120 below the sputtering cathodes 26 and through the substrate feeding and discharge openings 20, 22 of the coating chamber 10. During coating operation, the transport path 60 extends from the substrate feeding opening 20 to the substrate discharge opening 22.

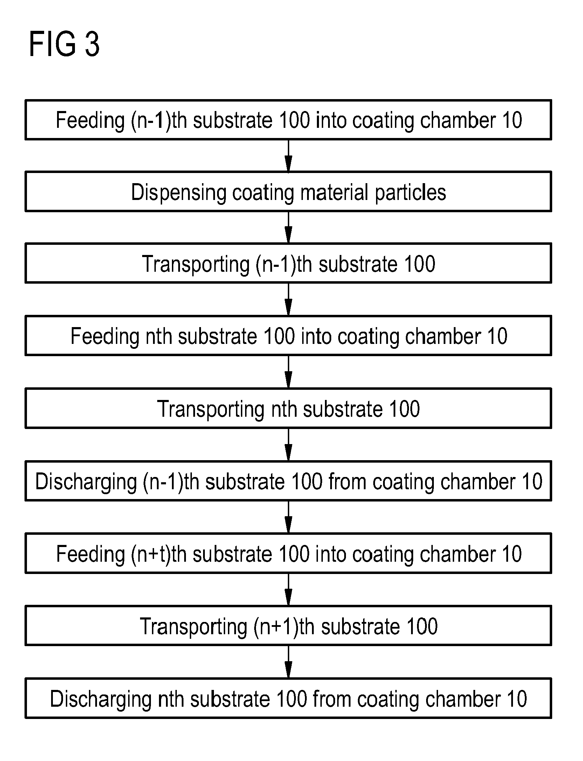

The following is an example of a coating method according to embodiments described herein, the beginning of which is shown schematically in Fig. 3. A front end of a first glass substrate 100 ((n-1)th glass substrate; n being an integer > 2) enters the coating chamber 10. The sputtering cathodes 26 are then switched on or, alternatively, are already working. The first glass substrate 100 is continuously transported below the operating sputtering cathodes 26 and through the coating chamber 10 while being coated on its front side 105 with Ag particles. After the rear end of the first glass substrate 100 has entered the coating chamber 10, the front end of a second (nth) glass substrate 100 is fed into the coating chamber 10 through the substrate feeding opening 20. The second glass substrate 100 is arranged on the rings 33 of the transport system 30 and transported thereon. Again, the second glass substrate 100 is continuously transported below the operating sputtering cathodes 26 and through the coating chamber 10 while being coated on its front side 105 with Ag particles. During conveying of the second glass substrate 100, after a first and a second period of time, the front end and the rear end of the continuously transported first glass substrate 100 consecutively arrive at and are discharged through the discharge opening 22. The first and the second periods of time depend on the length, i.e. the distance between the front and the rear ends, of the first glass substrate 100, as the skilled person is aware. Thereafter, the front end of the second glass substrate 100 arrives at the substrate discharge opening 22 and is discharged from the coating chamber 10. Finally, after a period of time depending on the length of the second glass substrate 100, its rear end is discharged through the substrate discharge opening 22, thus completing the process of coating the second glass substrate 100.

As shown in e.g. Fig. 2, each glass substrate 100 has one front side 105 to be coated and facing the sputtering cathodes 26 during transport of the glass substrate on the transport system 30. Each glass substrate 100 further includes a backside 110 opposite to the front side 105 and facing the transport system 30 during transport of the glass substrate thereon, and two lateral ends 112 each including a lateral side 114. During transport of the glass substrates 100 on the transport system 30, as illustrated in Fig. 2, gaps 500 may be formed between the lateral sides 114 of the glass substrates 100 and the sidewalls 17 of the coating chamber 10. Through gaps 500, a part of the transport system 30 may be exposed and may be undesirably coated by the Ag particles ejected from the sputtering cathode(s) 26.

A typical plasma sputtering cathode may include a casing, a target inside of the casing and a vapor aperture in the casing. The coating material particles ejected from the target travel through the vapor aperture into the coating chamber. Such a sputtering arrangement may result in a non-uniform thickness of the coating deposited on the substrates. For instance, the thickness uniformity of the coatings on the substrates may be about +/- 7%. In addition, parts of the casing around the vapor aperture, for instance shaper shields which are on ground potential, can influence the amount of coating material deposited on the substrate support, e.g. the transport system 30. Moreover, such parts or shaper shields can affect the erosion profile of the target, which may reduce the average useful life of the target.

In typical examples, the vapor aperture may be elongated and has two ends opposite to each other. Moreover, for instance in the coating chamber 10 for coating continuously transported substrates 100 shown in Figs. 1 and 2, the sputtering cathode 26 may be provided such that the elongated vapor aperture is positioned across the transport path 60. In some examples, the elongated vapor aperture may span the widths, i.e. the dimension perpendicular to the transport direction, of the plate-shaped substrates transported in front of the vapor aperture. In such sputtering installations, the coating thickness may be increased at the lateral ends 112 of the substrate 100.

According to embodiments described herein, a charged particle beam PVD device includes a target of coating material inside of a casing, a vapor aperture provided in the casing, and a shielding device provided adjacent to the vapor aperture, the shielding device being on floating potential.

As a result of the shielding device being on floating potential, the erosion profile of the target is improved. That means the target is eroded more uniformly, which extends the useful life of the target. The substantially uniform erosion of the target may be due to a shaping of the electrical field at the edges of the vapor aperture because of the floating potential of the shielding device positioned adjacent to the vapor aperture. Thereby, a potential gradient at the edges of the vapor aperture and/or across the vapor aperture can be adjusted, such that the plasma is not disadvantageously influenced and is distributed more evenly across the target. Moreover, inter alia because of a shadowing effect of the shielding device, the particles of the coating material are ejected from the target in a more substrate-oriented way. Hence, the coating thickness on the exposed parts, e.g. side parts, of the substrate support can be reduced, while the thickness of the coating deposited on the substrates is substantially uniform. Therefore, the time interval of cleaning the substrate support may be increased. In addition, since thick layers of coating material on the substrate support are avoided, which may absorb humidity from atmosphere when the chamber is vented, instabilities during the coating process may be obviated.

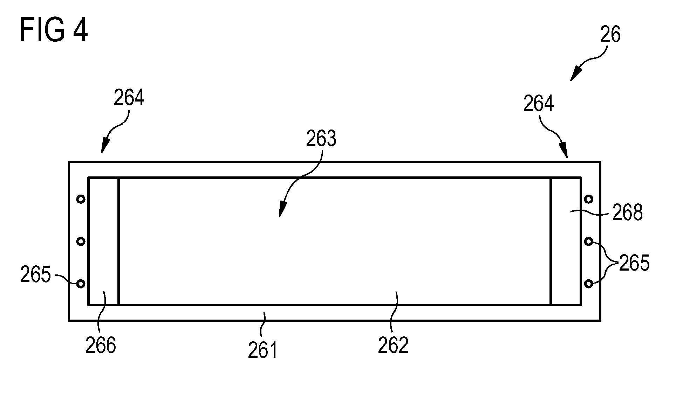

Fig. 4 illustrates schematically a bottom view of one of the plasma sputtering cathodes shown in Fig. 1. The sputtering cathode 26 includes a casing 261, a target 262 of coating material inside of the casing, and a vapor aperture 263 provided in the casing. Around the vapor aperture 263, the casing 261 or parts thereof, e.g. shaper shields (not shown), may be grounded. According to embodiments described herein, a shielding device 266, 268 is provided adjacent to the vapor aperture 263. The shielding device 266, 286 is provided on floating potential and/or consists of a vacuum compatible material or vacuum compatible materials. The shielding device may be positioned at the circumference of the vapor aperture. In some examples of embodiments, the shielding device may be formed as a cap encompassing and shielding the lateral region between the target 262 and the casing 261 around aperture 263. In the example shown in Fig. 4 the shielding device 266, 286 extends into the vapor aperture 263 and is positioned between the target 262 and the vapor aperture 263.

The distance of the shielding device from the target may be in a range of 40 mm to 70 mm or may typically be at least 55 mm. Such a distance may avoid a deformation or a deterioration of the shielding device because of high temperatures of the target during sputtering operation.

In the example shown in Fig. 4, the vapor aperture 263 has an elongated form with two ends 264 opposite to each other and the shielding device includes a first shield 266 provided at one end 264 and a second shield 268 provided at the other end 264. Typically, the vapor aperture 263 may have a length from one end 264 to the other end 264 in a range of about 900 mm to about 1800 mm, for instance of about 1560 mm. The first and second shields 266, 268 extend into the vapor aperture 263. The length of the resulting opening for releasing the coating material particles ejected from the target may typically be in a range of about 700 mm to about 1600 mm, for instance about 1360 mm.

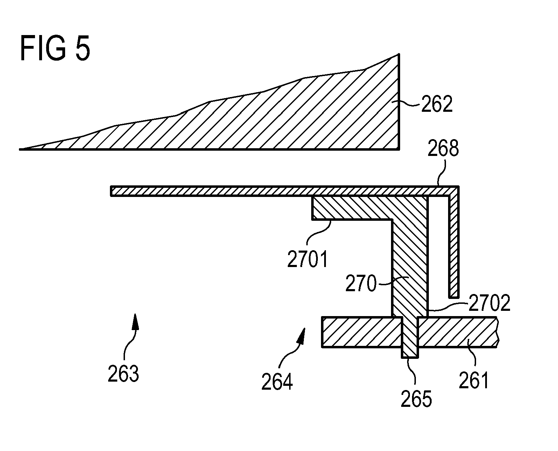

According to some examples of embodiments, the shielding device may be mounted to the casing via an isolating connector. Thereby, the shielding device is isolated from the casing, which may at least be partially grounded, and held on floating potential. As shown in Figs. 4 and 5, the shielding device may be mounted inside of the casing 261 between target 262 and casing 261 at isolated connector fixations 265.

Fig. 5 illustrates schematically a partial cross-sectional view of the right end 264 of the plasma sputtering device 26 shown in Fig. 4. As illustrated in Fig. 5, the shield 268 is mounted at the casing 261 adjacent to the aperture 263 by an isolating connector 270. The material of the isolating connector is electrically insulating, e.g. a vacuum compatible, heat resistant, synthetic material, such as materials on porcelain or carbon basis. The material of the isolating connector may for instance include or consist of at least one material selected from the group consisting of Teflon®, porcelain and PEEK. The isolating connector 270 allows keeping the shield 268 on floating potential. In some examples of embodiments, the isolating connector 270 has an L-type cross section having a short branch 2701 and a long branch 2702. The end of the long branch 2702 of the isolating connector 270 may be attached to the casing 261 close to the aperture 263 by isolated connector fixation 265. At the short branch 2701 of the isolating connector 270 the shield 268 may be mounted. Because of the L-type cross section and the arrangement of the isolating connector 270 as shown in Fig. 5, the lateral region between the target 262 and the casing 261 around aperture 263 is shielded. Moreover, in some examples as shown in Fig. 5, the shield 268 may be formed as a cap, additionally encompassing and shielding the lateral region between the target 262 and the casing 261 around aperture 263.

According to some embodiments, which may be combined with any other example of embodiment or embodiment described herein, the shielding device is mounted to the casing of the charged particle beam PVD device via an isolating connector having a self-shielding structure. Thereby, it is avoided or even prevented that the isolating properties of the isolating connector are deteriorated due to formation of a conducting film of ejected coating material on the surface of the isolating connector.

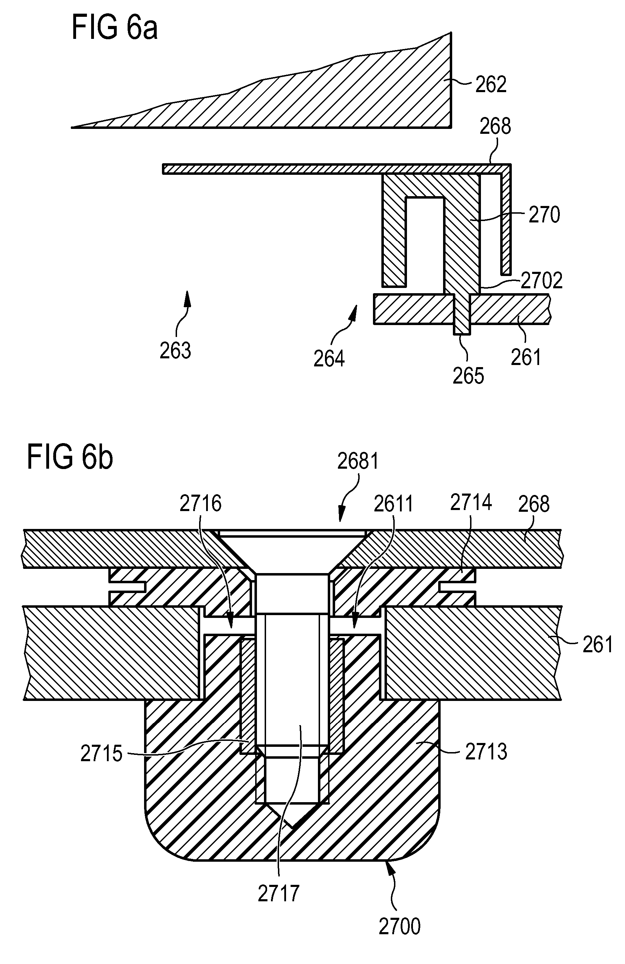

According to one example of embodiments including an isolating connector having a self-shielding structure, the isolating connector shown in Fig. 5 may have a further branch 2703 connected to the short branch 2701 and being directed to the casing 261, resulting in a U-type form of the connector. This example is illustrated in Fig. 6a. The further branch 2703 is slightly shorter than the long branch 2702, and therefore does not come into contact with the casing 261. The further branch 2703 shields the long branch 2702 from the plasma located between aperture 263 and target 262 and/or from sputtered coating material particles. Hence, during the sputtering procedure, formation of a conducting surface coating upon long branch 2702 is avoided. Thereby, the floating potential of shield 268 is maintained over a long running time of the charged particle beam PVD device, e.g. a sputtering device..

In some examples of embodiments, the vapor aperture is positioned between the shielding device and the target. For instance, the casing including the vapor aperture is located between the shielding device and the target. The distance between the vapor aperture and the shielding device, e.g. between the casing and the shielding device, may be in a range of about 1.5 mm to about 4 mm, more typically about 2 mm.

Another example of embodiments including an isolating connector 2700 having a self-shielding structure is shown in Fig. 6b. In this example, the casing including the vapor aperture (not shown in Fig. 6b) is positioned between the shielding device and the target (not shown in Fig. 6b). Further, the distance between the casing including the vapor aperture and the shielding device may be in a range of about 2 mm. The casing 261 includes a plurality of fixation openings 2611 around the vapor aperture for fixation of one of the shields, e.g. shield 268, of the shielding device. In the present example, the fixation opening 2611 of the casing 261 shown in Fig. 6b is cylindrical. The isolating connector 2700 includes in this example an isolating first part 2713 and an isolating second part 2714, which may each be formed of an electrically insulating material. The material of the isolating connector 2007 may be e.g. a vacuum compatible, heat resistant, synthetic material, such as materials on porcelain or carbon basis. The material of the isolating connector 2007 may for instance include or consist of at least one material selected from the group consisting of Teflon®, porcelain and PEEK. In one example, at least the isolating second part 2714 is formed of electrically insulating material. In the cylindrical opening 2611 of the casing 261, the isolating first part 2713 may be provided. The isolating first part 2713 has an internal thread 2715 for engaging with a fixation screw 2717. In some examples, the fixation screw may also be formed of electrically insulating material. The isolating first part 2713 may be mounted at the side of the casing 261, which faces the target (not shown in Fig. 6b). Isolating first part 2713 is adapted to be mounted such that it partially fills the opening 2611, the internal thread 2715 being accessible from the side of the casing 261 facing the substrate support (not shown in Fig. 6b). The isolating second part 2714 is formed as a ring, e.g. an insulating washer, which may be positioned above the opening 2611 at the side of the casing which faces the substrate support. In this position, between the isolating first part and the isolating second part 2713, 2714 of the isolating connector a gap 2716 may be provided, as shown in Fig. 6b. Over the isolating second part 2714, the shield 268 may be mounted. To this end, the shield 268 has openings 2681 at locations corresponding to the openings 2611 of the casing 261, when placing the shield into position thereon. The openings 2681 have dimensions adapted to receive the fixation screws 2717.

In the fixed state as shown in Fig. 6b, the screw 2717 fixes the shield 268 over the isolating second part 2714, extends through the opening 2611 into the isolating first part 2713 and is engaged in thread 2715. Thereby, the shield 268 and the isolating first and second parts 2713 and 2714 are fixed at the casing 261. Moreover, because of the gap 2716 and because of the insulating material of the isolating first and/or second parts 2713, 2714 and/or of the fixation screw 2717, the isolating connector 2700 keeps the shield 268 at floating potential. In addition, the isolating second part 2714 is located between the shield 268 and the casing 261, which have in the present example a distance of about 2 mm between each other. The isolating second part 2714 is therefore substantially shielded from vapor particles, which could form a conducting coating thereon. Moreover, since gap 2716 is not accessible for vapor particles, the isolating connector 2700 shields itself from being coated with a conducting coating inside of gap 2716. Hence, the formation of a conducting coating on isolating connector 2700, which could electrically connect the casing 261 and the shield 268, is avoided. Consequently, the floating potential of the shield 268 mounted on the casing 261 is not affected during a coating process using the charged particle beam PVD device of embodiments described herein, e.g. a sputtering device.

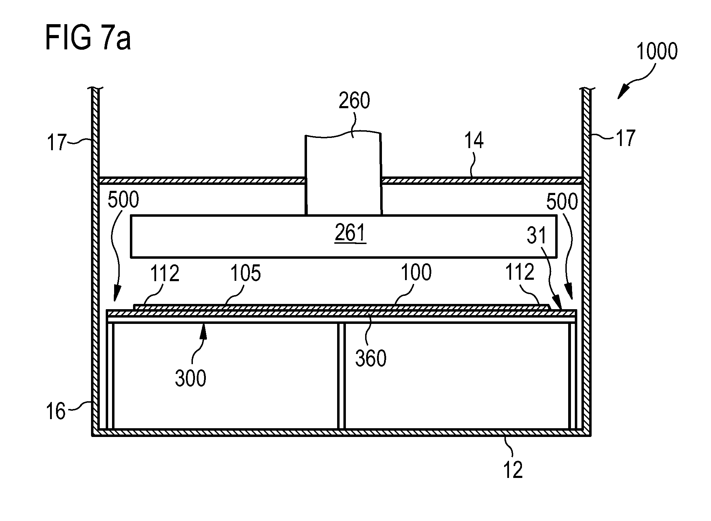

Fig. 7a illustrates, as another typical example, a cross-sectional view of a coating chamber 1000 designed as a vacuum sputtering chamber for thin-film coating of stationary supported glass substrates 100. The coating chamber 1000 includes a bottom wall 12, a top wall (not shown), a front wall (not shown), a rear wall (not shown) and two sidewalls 17. The material of all walls is stainless steel and the coating chamber 1000 is vacuum-tight. The coating chamber 1000 further has process gas inlets (not shown) and is connected to vacuum pumps (not shown) for establishing a vacuum. For example, a typical pressure range for sputtering is between 10⁻³ hPa to 10⁻² hPa, a typical pressure range for evaporation is from lower than 10⁻⁶ hPa to 10⁻³ hPa, more typically in the range from 10⁻⁵ hPa to 10⁻⁴ hPa.

On the bottom wall 12 of coating chamber 1000, a substrate support 300 for stationary supporting one or more glass substrates 100 is mounted. The substrate support 300 has a front side 31 facing the sputtering cathode 260 and is adapted for supporting on the front side 31 one or more plate-shaped glass substrates 100. The coating chamber 100 may include a substrate feeding opening (not shown) and/or a manipulator (not shown) for transferring the substrate(s) 100 into and out of the chamber 1000.

Furthermore, at the top wall 14 at least one plasma sputtering cathode 260, typically two sputtering cathodes 260, each including a target of Ag is provided as a plasma sputtering device for dispensing coating material into the coating chamber 1000. The plasma sputtering cathode 260 is also referred to herein as sputtering cathode 260.

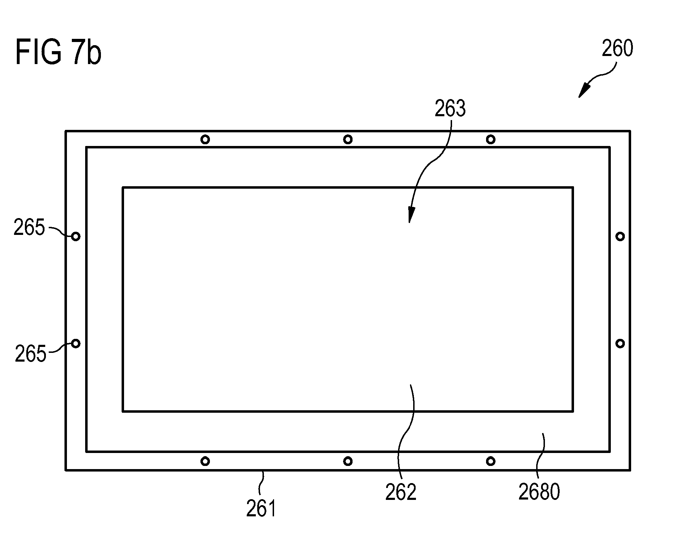

Fig. 7b shows a bottom view of sputtering cathode 260 which includes a casing 261, a target 262 and a sputtering aperture 263. Around sputtering aperture 263 a shielding device formed as a shielding frame 2680 is mounted inside of and at the casing 261 close to the aperture via isolating connectors (not shown) at isolated connector fixations 265. Thereby, the shielding frame 2680 is isolated from the casing and held at floating potential. The isolating connectors may have a self-shielding structure, e.g. as described above with reference to Fig. 6. In some examples, as mentioned referring to the example of Fig. 5, the shield 2680 may be formed as a cap and/or the isolating connector may have a form, such that the lateral region between the target 262 and the casing 261 around aperture 263 is encompassed and shielded.

As a consequence of the shielding device including the shielding frame 2680 being on floating potential, the erosion profile of the target of sputtering cathode 260 is improved. That means the target is eroded more uniformly, which extends the useful life of the target. The substantially uniform erosion of the target may be due to a shaping of the electrical field at the edges of the vapor aperture because of the floating potential of the shielding device positioned adjacent to the vapor aperture. Thereby, a potential gradient at the edges of the vapor aperture and/or across the vapor aperture can be adjusted, such that the plasma is not disadvantageously influenced and is distributed more evenly across the target. Moreover, inter alia because of a shadowing effect of the shielding device, the particles of the coating material are ejected from the target in a more substrate-oriented way. Hence, the coating thickness on the exposed parts, e.g. side parts, of the substrate support can be reduced, while the thickness of the coating deposited on the substrates is substantially uniform. Therefore, the time interval of cleaning the substrate support may be increased. In addition, since thick layers of coating material on the substrate support are avoided, which may absorb humidity from atmosphere when the chamber is vented, instabilities during the coating process may be obviated.

Hence, according to one embodiment, a method of coating one or more substrates in a coating chamber includes: providing a substrate on a substrate support of the coating chamber having a charged particle beam PVD device according to any of above mentioned examples of embodiments or embodiments, and dispensing coating material from the charged particle beam PVD device towards the substrate.

According to another embodiment, a method of coating one or more substrates in a coating chamber includes: providing a coating chamber according to any of above mentioned examples of embodiments or embodiments, providing a substrate on the substrate support of the coating chamber, and dispensing coating material from the charged particle beam PVD device provided in the coating chamber towards the substrate.

For instance, these methods may be performed using coating chamber 10 or coating chamber 1000 described above including the plasma sputtering cathodes 26 or 260, respectively, as a charged particle beam PVD device.

For example, in a coating method using coating chamber 10, the substrates 100 are transported continuously or discontinuously below the operating sputtering cathode 26. Since cathode 26 has the shields 266, 268 on floating potential at both ends of the sputtering aperture 263, the thickness of the coatings deposited on the substrates 100 may be substantially uniform across the whole width of the substrates, even at the lateral ends 112 thereof. For instance, a thickness uniformity of the coating on the substrates 100 of about +/- 3.5% can be achieved using coating chamber 10 including the sputtering cathode 26.

Further, as a result of performing a coating process on one or more substrates 100 using chamber 1000 including cathode 260, the thickness of the coatings deposited on the substrates 100 may be substantially uniform across the whole area of the substrates, even at the peripheries thereof.

Moreover, as mentioned above, when conducting the above methods, the erosion profiles of the sputtering cathodes 26 and 260, which each include the shielding device on floating potential, are improved. As an example, in the following, a long-term testing procedure inspecting the target profile at different measuring points (mp) of an example of sputtering cathode 26, having an elongated Al target with two opposite ends 264, is presented.

**Table 1**

| Test | Running time [h] | Applied Energy [kW/h] | Thickness of eroded Al [mm] at one end of the target | | | Thickness of eroded Al [mm] in the center of the target | | | | |
|---|---|---|---|---|---|---|---|---|---|---|
| | total | total | mp 1 | mp 2 | mp 3 | mp 4 | mp 5 | mp 6 | mp 7 | mp 8 |
| | 53 | 1540 | 3.6 | 3.5 | 3.5 | 2.8 | 3.9 | 3.8 | 3.7 | 3.6 |

As can be taken from table 1, after operating the Al target for 53 hours and exposing it to a total energy of 1540 kW/h, the Al target has been substantially uniformly eroded, the thickness of the eroded Al material being in a range of about 3.4 mm +/- 0.6 mm across the length of the target.

In one embodiment, a charged particle beam PVD device is provided, including a target of coating material inside of a casing, a vapor aperture provided in the casing, and a shielding device provided adjacent to the vapor aperture, the shielding device being on floating potential.

In one embodiment, which may be combined with any other embodiment disclosed herein, the shielding device is positioned at the circumference of the vapor aperture.

In one embodiment, which may be combined with any other embodiment disclosed herein, the shielding device extends into the vapor aperture.

In one embodiment, which may be combined with any other embodiment disclosed herein, the shielding device is positioned between the target of coating material and the vapor aperture, or the vapor aperture is positioned between the shielding device and the target of coating material.

In one embodiment, which may be combined with any other embodiment disclosed herein, the shielding device is mounted to the casing via an isolating connector.

In one embodiment, which may be combined with any other embodiment disclosed herein, the shielding device is mounted to the casing via an isolating connector having a self-shielding structure.

In one embodiment, which may be combined with any other embodiment disclosed herein, the vapor aperture has an elongated form with two ends opposite to each other and the shielding device includes at least one element selected from the group consisting of a first shield provided at one of the ends and a second shield provided at the other end.

In one embodiment, which may be combined with any other embodiment disclosed herein, the distance of the shielding device from the target is in a range of 40 mm to 70 mm.

In one embodiment, which may be combined with any other embodiment disclosed herein, the distance of the shielding device from the target is at least 55 mm.

In one embodiment, which may be combined with any other embodiment disclosed herein, the charged particle beam PVD device is at least one element selected from an electron beam PVD device, an ion beam PVD device, a sputtering device, a plasma sputtering device, a charged particle beam sputtering device, an electron beam sputtering device, and an ion beam sputtering device.

In one embodiment, a shielding device for a charged particle beam PVD device is provided, the charged particle beam PVD device including an target of coating material inside of a casing and a vapor aperture provided in the casing, the shielding device being adapted to be provided adjacent to the vapor aperture and being adapted to be provided on floating potential.

One embodiment, which may be combined with any other embodiment disclosed herein, includes an isolating connector having a self-shielding structure and being adapted for mounting the shielding device to a charged particle beam PVD device.

In one embodiment, a coating chamber for coating substrates is provided, including a substrate support, and a charged particle beam PVD device including a target of coating material inside of a casing, a vapor aperture provided in the casing, and a shielding device provided adjacent to the vapor aperture, the shielding device being on floating potential.

In one embodiment, which may be combined with any other embodiment disclosed herein, the shielding device includes an isolating connector having a self-shielding structure and being adapted for mounting the shielding device to the charged particle beam PVD device.

In one embodiment, which may be combined with any other embodiment disclosed herein, the substrate support includes a transport system adapted to transport the one or more substrates along a transport path, the charged particle beam PVD device includes an elongated vapor aperture with two ends opposite to each other and the shielding device includes at least one element selected from the group consisting of a first shield provided at one of the ends and a second shield provided at the other end, and wherein the charged particle beam PVD device is provided in the coating chamber such that the elongated vapor aperture is positioned across the transport path.

In one embodiment, which may be combined with any other embodiment disclosed herein, the transport path has two boundaries opposite to each other and the charged particle beam PVD device is provided in the coating chamber such that the first shield faces one boundary of the transport path and the second shield faces the other boundary of the transport path.

In one embodiment, a method of coating one or more substrates in a coating chamber is provided, including: providing a substrate on a substrate support of the coating chamber having a charged particle beam PVD device, wherein the charged particle beam PVD device includes a target of coating material inside of a casing, a vapor aperture provided in the casing, and a shielding device provided adjacent to the vapor aperture, the shielding device being on floating potential; and dispensing coating material from the charged particle beam PVD device towards the substrate.

In one embodiment of the method, which may be combined with any other embodiment disclosed herein, the shielding device is mounted to the casing via at least one element selected from the group consisting of an isolating connector and an isolating connector having a self-shielding structure.

In one embodiment of the method, which may be combined with any other embodiment disclosed herein, the substrate support includes a transport system adapted to transport the one or more substrates along a transport path, the charged particle beam PVD device includes an elongated vapor aperture with two ends opposite to each other and the shielding device includes at least one element selected from the group consisting of a first shield provided at one of the ends and a second shield provided at the other end, and wherein
the charged particle beam PVD device is provided in the coating chamber such that the elongated vapor aperture is positioned across the transport path of the substrates.

In one embodiment, which may be combined with any other embodiment disclosed herein, the method further includes providing the substrate by feeding the substrate into the coating chamber and arranging the substrate on the substrate support, continuously or discontinuously transporting the substrate by the transport system along the transport direction while dispensing coating material from the charged particle beam PVD device, and discharging the substrate from the coating chamber.

In one embodiment of the method, which may be combined with any other embodiment disclosed herein, the transport path has two boundaries opposite to each other and the charged particle beam PVD device is provided in the coating chamber such that the first shield faces one boundary of the transport path and the second shield faces the other boundary of the transport path.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A charged particle beam PVD device, comprising
a target (262) of coating material inside of a casing (261),
a vapor aperture (263) provided in the casing, and
a shielding device (266, 268; 2680) provided adjacent to the vapor aperture, the shielding device being on floating potential.

2. The charged particle beam PVD device of claim 1, wherein the shielding device is positioned at the circumference of the vapor aperture and/or extends into the vapor aperture.

3. The charged particle beam PVD device of claim 1 or 2, wherein the shielding device is positioned between the target of coating material and the vapor aperture, or wherein the vapor aperture is positioned between the shielding device and the target of coating material.

4. The charged particle beam PVD device of any of the preceding claims, wherein the shielding device is mounted to the casing via an isolating connector (270).

5. The charged particle beam PVD device of any of the preceding claims, wherein the shielding device is mounted to the casing via an isolating connector (270) having a self-shielding structure.

6. The charged particle beam PVD device of any of the preceding claims, wherein the vapor aperture has an elongated form with two ends opposite to each other and the shielding device includes a first shield provided at one of the ends and/or a second shield provided at the other end.

7. The charged particle beam PVD device of any of the preceding claims, wherein the distance of the shielding device from the target is in a range of 40 mm to 70 mm and/or is at least 55 mm.

8. The charged particle beam PVD device of any of the preceding claims, wherein the charged particle beam PVD device is at least one element selected from an electron beam PVD device, an ion beam PVD device, a sputtering device, a plasma sputtering device, a charged particle beam sputtering device, an electron beam sputtering device, and an ion beam sputtering device.

9. A shielding device for a charged particle beam PVD device,
the charged particle beam PVD device comprising a target (262) of coating material inside of a casing (261) and
a vapor aperture (263) provided in the casing,
the shielding device (266, 268; 2680) being adapted to be provided adjacent to the vapor aperture and being adapted to be provided on floating potential.

10. The shielding device of claim 9, comprising an isolating connector (270) having a self-shielding structure and being adapted for mounting the shielding device to a charged particle beam PVD device (26; 260).

11. A coating chamber for coating substrates,
comprising
a substrate support (30; 300) and
a charged particle beam PVD device (26; 260) according to any of claims 1 to 8.

12. The coating chamber of claim 11, wherein
the substrate support includes a transport system (30) adapted to transport the one or more substrates along a transport path (60),
the charged particle beam PVD device comprises an elongated vapor aperture with two ends opposite to each other and the shielding device includes a first shield (266) provided at one of the ends and/or a second shield (268) provided at the other end, and wherein
the charged particle beam PVD device is provided in the coating chamber such that the elongated vapor aperture is positioned across the transport path .

13. The coating chamber of claim 12, wherein
the transport path (60) has two boundaries opposite to each other and the charged particle beam PVD device is provided in the coating chamber such that the first shield faces one boundary of the transport path and the second shield faces the other boundary of the transport path.

14. A method of coating one or more substrates in a coating chamber, comprising
providing a substrate (100) on a substrate support (30; 300) of the coating chamber having a charged particle beam PVD device (26; 260) according to any of claims 1 to 8, and
dispensing coating material from the charged particle beam PVD device (26; 260) towards the substrate (100).

15. The method of claim 14, wherein the coating chamber is a coating chamber according to any of claims 11 to 13.

## Amended claims

### Amended claims in accordance with Rule 137(2) EPC.

**1.** A charged particle beam PVD device, comprising
a target (262) of coating material inside of a casing (261),
a vapor aperture (263) provided in the casing, and
a shielding device (266, 268; 2680) provided adjacent to the vapor aperture, the shielding device being on floating potential,
wherein the shielding device is mounted to the casing via an isolating connector (270) having a self-shielding structure.

**2.** The charged particle beam PVD device of claim 1, wherein the shielding device is positioned at the circumference of the vapor aperture and/or extends into the vapor aperture.

**3.** The charged particle beam PVD device of claim 1 or 2, wherein the shielding device is positioned between the target of coating material and the vapor aperture, or wherein the vapor aperture is positioned between the shielding device and the target of coating material.

**4.** The charged particle beam PVD device of any of the preceding claims, wherein the shielding device is mounted to the casing via an isolating connector (270).

**5.** The charged particle beam PVD device of any of the preceding claims, wherein the vapor aperture has an elongated form with two ends opposite to each other and the shielding device includes a first shield provided at one of the ends and/or a second shield provided at the other end.

**6.** The charged particle beam PVD device of any of the preceding claims, wherein the distance of the shielding device from the target is in a range of 40 mm to 70 mm and/or is at least 55 mm.

**7.** The charged particle beam PVD device of any of the preceding claims, wherein the charged particle beam PVD device is at least one element selected from an electron beam PVD device, an ion beam PVD device, a sputtering device, a plasma sputtering device, a charged particle beam sputtering device, an electron beam sputtering device, and an ion beam sputtering device.

**8.** A shielding device for a charged particle beam PVD device,
the charged particle beam PVD device comprising a target (262) of coating material inside of a casing (261) and
a vapor aperture (263) provided in the casing,
the shielding device (266, 268; 2680) being adapted to be provided adjacent to the vapor aperture and being adapted to be provided on floating potential,
wherein the shielding device comprises an isolating connector (270) having a self-shielding structure and being adapted for mounting the shielding device to the charged particle beam PVD device (26; 260).

**9.** A coating chamber for coating substrates,
comprising
a substrate support (30; 300) and
a charged particle beam PVD device (26; 260) according to any of claims 1 to 7.

**10.** The coating chamber of claim 9, wherein
the substrate support includes a transport system (30) adapted to transport the one or more substrates along a transport path (60),
the charged particle beam PVD device comprises an elongated vapor aperture with two ends opposite to each other and the shielding device includes a first shield (266) provided at one of the ends and/or a second shield (268) provided at the other end, and wherein
the charged particle beam PVD device is provided in the coating chamber such that the elongated vapor aperture is positioned across the transport path.

**11.** The coating chamber of claim 10, wherein
the transport path (60) has two boundaries opposite to each other and the charged particle beam PVD device is provided in the coating chamber such that the first shield faces one boundary of the transport path and the second shield faces the other boundary of the transport path.

**12.** A method of coating one or more substrates in a coating chamber, comprising
providing a substrate (100) on a substrate support (30; 300) of the coating chamber having a charged particle beam PVD device (26; 260) according to any of claims 1 to 7, and
dispensing coating material from the charged particle beam PVD device (26; 260) towards the substrate (100).

**13.** The method of claim 12, wherein the coating chamber is a coating chamber according to any of claims 9 to 11.
